(19) Europäisches Patentamt
European Patent Office
Office européen des brevets

(11) **EP 4 481 818 A1**

(12) **EUROPEAN PATENT APPLICATION**

(43) Date of publication:
**25.12.2024 Bulletin 2024/52**

(21) Application number: **24175039.7**

(22) Date of filing: **09.05.2024**

(51) International Patent Classification (IPC):
**H01L 25/16** (2023.01)   **H01L 27/15** (2006.01)
**H01L 33/50** (2010.01)   **H01L 33/00** (2010.01)

(52) Cooperative Patent Classification (CPC):
**H01L 25/167; H01L 27/156;** H01L 33/0095;
H01L 33/50

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **19.06.2023 US 202363521750 P
29.08.2023 KR 20230113737**

(71) Applicant: **Samsung Electronics Co., Ltd.
Suwon-si, Gyeonggi-do 16677 (KR)**

(72) Inventors:
• **LEE, Eunsung**
  **16678, Suwon-si, (KR)**
• **KONG, Kiho**
  **16678, Suwon-si, (KR)**
• **CHOI, Junhee**
  **16678, Suwon-si, (KR)**
• **KIM, Nakhyun**
  **16678, Suwon-si, (KR)**

(74) Representative: **Elkington and Fife LLP
Prospect House
8 Pembroke Road
Sevenoaks, Kent TN13 1XR (GB)**

(54) **DISPLAY APPARATUS AND METHOD OF MANUFACTURING THE SAME**

(57)     Provided are a display apparatus and a method of manufacturing the display apparatus. The display apparatus includes a pixel electrode configured to supply power to a subpixel; a common electrode; an organic transparent substrate; a driving layer provided on the organic transparent substrate and electrically connected to the pixel electrode, the driving layer including a driving device configured to control power on-off of the subpixel; and a light emitting unit provided on the driving layer and including an inorganic material, the light emitting unit including a first semiconductor layer, an active layer, and a second semiconductor layer.

FIG. 20

## Description

FIELD OF THE INVENTION

Example embodiments of the disclosure relate to a flexible high resolution display apparatus and a method of manufacturing the same.

BACKGROUND OF THE INVENTION

Liquid crystal displays (LCDs), organic light emitting diode (OLED) displays, and light emitting diode (LED) displays are widely used as display apparatuses. Recently, interest in flexible display apparatuses has increased. In general, OLED displays have been largely used as flexible apparatuses, but OLED displays have relatively weak luminance compared to inorganic LED displays.

SUMMARY OF THE INVENTION

Example embodiments of the disclosure provide a flexible high resolution display apparatus.

Example embodiments of the disclosure provide a method of manufacturing a flexible high resolution display apparatus.

Additional aspects will be set forth in part in the description which follows and, in part, will be apparent from the description, or may be learned by practice of the presented embodiments of the disclosure.

According to an aspect of the disclosure, provided is a display apparatus including: a pixel electrode configured to supply power to a subpixel; a common electrode; an organic transparent substrate; a driving layer provided on the organic transparent substrate and electrically connected to the pixel electrode, the driving layer including a driving device configured to control power on-off of the subpixel; and a light emitting unit provided on the driving layer and including an inorganic material, the light emitting unit including a first semiconductor layer, an active layer, and a second semiconductor layer.

The organic transparent substrate may include at least one of polyimide, polymethyl methacrylate (PMMA), plexiglass, polyethylene terephthalate (PET), transparent polypropylene, polycarbonate, polyethylene naphthalate, polyarylate (PAR), polyetherimide, or any combination thereof.

The display apparatus may be a flexible display apparatus or a rollable display apparatus.

The display apparatus may further include a coupling layer between the organic transparent substrate and the driving layer.

The coupling layer may include at least one of benzocyclobutene (BCB), epoxy, or spin on glass (SOG).

The light emitting unit may include a light emitting diode (LED) array structure.

The driving layer may have a thickness of about 2 $\mu$m or less.

The light emitting unit may have a thickness of about 2 $\mu$m to about 3 $\mu$m.

The display apparatus may have a pixel integration degree equal to or greater than 2,000 pixels per inch (ppi).

The driving layer and the light emitting unit may have a monolithic integration structure.

The light emitting unit may include an isolated structure that isolates at least a part of a light emitting structure on a subpixel basis.

The display apparatus may further include a current blocking layer in an area corresponding to the isolated structure of the driving layer.

The display apparatus may further include a plurality of color conversion layers configured to convert light emitted from the light emitting unit into light with different colors.

According to another aspect of the disclosure, provided is a method of manufacturing a display apparatus, including: forming a first semiconductor layer on an epitaxial substrate; forming an active layer on the first semiconductor layer, the active layer including an inorganic material; forming a second semiconductor layer on the active layer; isolating the active layer on a subpixel basis by forming isolated structures on the active layer at an interval corresponding to a subpixel; forming a first electrode on a subpixel basis on the second semiconductor layer; forming a driving layer including a driving device, the driving device being electrically connected to the first electrode; positioning the driving layer to face down and coupling the driving layer to an organic transparent substrate; removing the epitaxial substrate;, and forming a second electrode on the first semiconductor layer.

The isolating the active layer on a subpixel basis may include forming an ion implantation area.

The organic transparent substrate may include at least one of polyimide, polymethyl methacrylate (PMMA), plexiglass, polyethylene terephthalate (PET), transparent polypropylene, polycarbonate, polyethylene naphthalate, polyarylate (PAR), polyetherimide, or any combination thereof.

The organic transparent substrate may be a flexible transparent substrate.

The forming the driving layer may form the driving layer that has a thickness of about 2 $\mu$m or less.

The forming the first semiconductor layer, the forming the active layer, and the forming the second semiconductor layer may form a light emitting unit that has a thickness of about 2 $\mu$m to about 3 $\mu$m.

The forming the isolated structures and the forming the first electrode may be based on a subpixel basis that corresponds to a pixel integration degree greater than or equal to 2,000 pixels per inch (ppi).

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 schematically shows a display apparatus according to an embodiment;
FIG. 2 shows an example in which the display apparatus shown in FIG. 1 further includes a color conversion layer;
FIG. 3 shows an example in which a display apparatus is applied to a flexible display apparatus, according to an embodiment;
FIG. 4 shows an example in which a display apparatus is applied to a contact lens-type display apparatus, according to an embodiment;
FIG. 5 shows an example in which a display apparatus is applied to a rollable display apparatus, according to an embodiment;
FIG. 6 shows a display apparatus according to an embodiment;
FIG. 7 shows a display apparatus further including a color conversion layer in a structure shown in FIG. 6;
FIG. 8 shows an example of a display apparatus in which an electrode structure is modified from the display apparatus shown in FIG. 7;
FIGS. 9 to 18 show a method of manufacturing a display apparatus, according to an embodiment;
FIG. 19 shows a method of forming a transparent electrode of a display apparatus, according to an embodiment; and
FIG. 20 shows a method of forming a color conversion layer in a structure shown in FIG. 18.

DETAILED DESCRIPTION

Reference will now be made in detail to embodiments, examples of which are illustrated in the accompanying drawings, wherein like reference numerals refer to like elements throughout. In this regard, example embodiments may have different forms and should not be construed as being limited to the descriptions set forth herein. Accordingly, the example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, a display apparatus and a method of manufacturing the same according to various example embodiments will be described in detail with reference to the accompanying drawings. In the following drawings, the same reference refers to the same component, and the size of each component in the drawings may be exaggerated for the clarity of the description and convenience. The terms such as "first" and "second" are used herein merely to describe a variety of components, but the components are not limited by the terms. The terms are used only for the purpose of distinguishing one component from another component.

The singular forms are intended to include the plural forms as well, unless the context clearly indicates otherwise. When a certain part "includes" a certain component, this indicates that the part may further include another component instead of excluding another component unless there is no different disclosure. The size and thickness of each component may be exaggerated for the clarity of the description. In addition, when a certain material layer is described as being on a substrate or another layer, the material layer may be present in direct contact with a substrate or another layer, or another third layer may be present therebetween. In the following embodiments, materials that make up each layer are exemplary, and thus other materials may be used.

In a case in which a certain component is described as being "connected" or "coupled" to another component, it should be understood that, although the component may be directly connected or coupled to the other component, still another component may also be "connected" or "coupled" between the two components.

Here, the expression "disposed on" includes the case where an element is disposed on another element so as to be in direct contact, as well as the case where the element is disposed over another element without being in direct contact with that element (e.g., another element interposed between the two elements).

The terms, such as "unit" or "module", need to be understood as a unit that processes at least one function or operation and that may be embodied in a hardware manner, a software manner, or a combination of the hardware manner and the software manner.

Certain executions described in the example embodiment are illustrate purposes only, not limiting the technical scope of the disclosure in any way. For the simplicity of the specification, the description of the existing electronic configurations, control systems, software, and other functional aspects of the system may be omitted. In addition, connection or connection members of lines between components shown in the drawing are exemplary of functional and/or physical or circuit connections, and are replaced in actual devices or are expressed as various functional connections, physical connections, or circuit connections.

The use of the terms of "the" and the use of similar terms may correspond to both singular and plurality.

Operations of a method may be performed in any suitable order unless otherwise indicated herein or otherwise clearly contradicted by context. In addition, the use of all exemplary terms (e.g., and the like, or the like) is to simply explain the technical detail and these terms do not limit the scope unless limited by the claims.

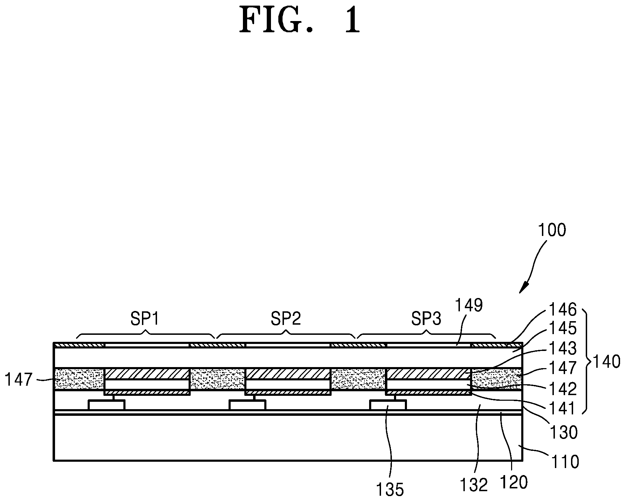

FIG. 1 shows a display apparatus 100 according to an embodiment.

Referring to FIG. 1, the display apparatus 100 includes a plurality of pixels. For convenience, only one pixel is illustrated in FIG. 1. A pixel may be a unit in which an image is displayed. Each of pixels may include subpixels that emit light with different colors. An image may be displayed by controlling color and light intensity from each subpixel. For example, each of the pixels may include a first subpixel SP1, a second subpixel SP2, and a third subpixel SP3.

The display apparatus 100 may include an organic transparent substrate 110, a driving layer 130 provided on the organic transparent substrate 110, and a light emitting unit 140 provided in the driving layer 130.

The organic transparent substrate 110 has flexibility and may be a substrate for supporting the driving layer 130 and the light emitting unit 140 that are disposed on or above the organic transparent substrate 110. That is, the organic transparent substrate 110 may not be a growth substrate. For example, the organic transparent substrate 110 may be a flexible transparent substrate and may include, for example, polyimide, polymethyl methacrylate (PMMA), plexiglass, polyethylene terephthalate (PET), transparent polypropylene, polycarbonate, polyethylene naphthalate, polyarylate (PAR), polyetherimide, or any combination thereof.

The driving layer 130 may include a driving device 135 configured to electrically drive the light emitting unit 140. The driving device 135 may control power on-off of a subpixel (that is, control power on a subpixel basis). The driving device 135 may include, for example, a transistor, a thin film transistor, or a high electron mobility transistor (HEMT). The driving layer 130 may further include at least one insulating layer 132.

A coupling layer 120 may be provided between the organic transparent substrate 110 and the driving layer 130. The coupling layer 120 may be used to couple the driving layer 130 to the organic transparent substrate 110, and for example, may include an adhesive layer or a direct bonding layer. The adhesive layer may include, for example, epoxy, spin on glass (SOG), or a benzocyclobutene (BCB). The direct bonding layer may be formed, for example, via plasma or ion beam processing. The coupling layer 120 may be used to physically couple the driving layer 130 to the organic transparent substrate 110, and may couple the driving layer 130 to the organic transparent substrate 110 using a bonding method without electrical connection.

The light emitting unit 140 may include a micro light emitting diode (LED) array. The light emitting unit 140 may include a first semiconductor layer 142, an active layer 143, and a second semiconductor layer 145 that are stacked in the order named. The first semiconductor layer 142, the active layer 143, and the second semiconductor layer 145 may form a light emitting structure.

The first semiconductor layer 142 may include a first type semiconductor. For example, the first semiconductor layer 142 may include a p-type semiconductor. The first semiconductor layer 142 may include Group III-V p-type semiconductors, for example, p-GaN. The first semiconductor layer 142 may have a single or multilayer structure.

The active layer 143 may be provided on an upper surface of the first semiconductor layer 142. The active layer 143 may include an inorganic material and may generate light by combining electrons and holes. The active layer 143 may have a multi-quantum well (MQW) or single quantum well (SQW) structure. The active layer 143 may include a Group III-V semiconductor, for example, GaN.

The second semiconductor layer 145 may be provided on an upper surface of the active layer 143. The second semiconductor layer 145 may include a second type semiconductor. The second semiconductor layer 145 may include, for example, an n-type semiconductor. In an example, the second semiconductor layer 145 may include a p-type semiconductor. The second semiconductor layer 145 may include a Group III-V n-type semiconductor, for example, n-GaN. The second semiconductor layer 145 may have a single or multilayer structure.

The light emitting unit 140 may have an isolated structure 147 such that light from the active layer 143 is emitted on a subpixel basis. In other words, the light emitting unit 140 may have the isolated structure 147 between neighboring subpixels. The isolated structure 147 may be, for example, an ion implantation area. Here, ions may include, for example, nitrogen (N) ions, boron (B) ions, argon (Ar) ions, or phosphorus (P) ions. A current is not injected in the ion implantation area, and thus light is not emitted therefrom, and when the isolated structure 147 is configured as an ion implantation area, the light emitting unit 140 may be formed without a mesa structure. In other words, the light emitting unit 140 may implement a micro light emitting device array structure by using the isolated structure 147 without an etching process. Because an etching process is not used, it may be possible to manufacture a subpixel with a small size, and thus it may be possible to manufacture a high resolution micro light emitting device array. For example, the display apparatus 100 may have a pixel integration degree of 2,000 ppi or more.

The driving layer 130 and the light emitting unit 140 may have a monolithic integration structure. As the thickness and pixel size of the display apparatus 100 are reduced according to these structural characteristics, the organic transparent substrate 110 may support the driving layer 130 and the light emitting unit 140, and flexible or rollable characteristics of the display apparatus 100 may be achieved. For example, the driving layer 130 may have a thickness of about 0 μm to about 2 μm or less. For example, the light emitting unit 140 may have a thickness of about 2 μm to about 3 μm. The display apparatus 100 may include an inorganic light emitting unit 140 but may have flexibility such that the display apparatus 100 may be applied to a flexible display apparatus or a rollable display apparatus.

The display apparatus 100 may include a first electrode 141 electrically connected to the first semiconductor layer 142, and a second electrode 146 electrically connected to the second semiconductor layer 145. The first electrode 141 may be a pixel electrode, and the second electrode 146 may be a common electrode. When the first and second semiconductor layers 142 and 145 include a p-type semiconductor and an n-type semiconductor, respectively, the first and second electrodes 141 and 146 may be a p-type electrode and an n-type electrode, respectively. The driving device 135 may be electrically connected to the first electrode 141 and may control power on-off of the first electrode 141 and the second electrode 146. Therefore, the driving device 135 may selectively drive at least one desired subpixel of the plurality of subpixels SP1, SP2, and SP3.

The first electrode 141 may include a reflective material to reflect light emitted from the active layer 143 in a downward direction (that is, toward the organic transparent substrate 110). The first electrode 141 may include, for example, Ag, Au, Al, Cr, Ni, or an alloy thereof. The second electrode 146 may be a transparent electrode or an opaque electrode. The transparent electrode may include, for example, indium tin oxide (ITO), ZnO, indium zinc oxide (IZO), or IGZO. When the second electrode 146 is formed as a transparent electrode, the second electrode 146 may be disposed to entirely cover the second semiconductor layer 145. When the second electrode 146 is an opaque electrode, the display apparatus 100 may further include a window region 149 to allow light emitted from the active layer 143 to be transmitted therethrough. FIG. 1 shows an example in which the display apparatus 100 includes the window region 149.

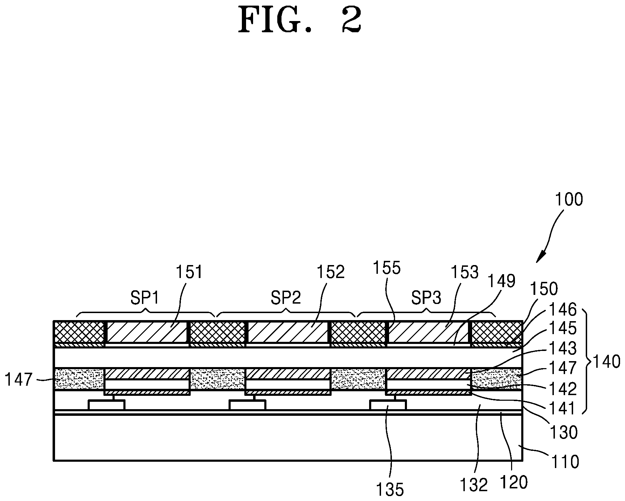

FIG. 2 shows an example in which the display apparatus 100 shown in FIG. 1 further includes a color conversion layer. FIG. 2 will be described with regards to a difference from FIG. 1.

A plurality of color conversion layers 151, 152, and 153 configured to emit light of different color by using light emitted from the active layer 143 may be disposed above the light emitting unit 140. The active layer 143 may emit light, for example, blue light. However, the light emitted from the active layer 143 is not limited thereto, and any light with other wavelengths may also be used as long as the light excites the color conversion layer 151, 152, and 153. The plurality of color conversion layers 151, 152, and 153 may be provided to correspond to the subpixels SP1, SP2, and SP3, respectively. The plurality of color conversion layers 151, 152, and 153 may include, for example, a blue conversion layer, a green conversion layer, and a red conversion layer. A blue conversion layer 151 may be provided to correspond to a blue subpixel, a green conversion layer 152 may be provided to correspond to a green subpixel, and a red conversion layer 153 may be provided to correspond to a red subpixel.

The blue conversion layer 151 may include a material for emitting blue light or may be a transmissive layer for passing blue light emitted from the active layer 143.

When blue light is emitted from the active layer 143, the blue conversion layer 151 may transmit light emitted from the active layer 143 and emit the light to the outside. The blue conversion layer 151 may further include a photoresist with high transmission characteristics or light scattering agent.

The green conversion layer 152 may convert light emitted from the active layer 143 into green light and emit the green light. The green conversion layer 152 may include, for example, quantum dots (QDs) with a certain size, which are excited by blue light and emit green light. The QD may have a core-shell structure having a core part and a shell part, and may also have a particle structure without shell. The core-shell structure may have a single-shell or a multi-shell. The multi-shell may be, for example, a double-shell.

The QD may include at least one of, for example, a Group II-VI semiconductor, a Group III-V semiconductor, a Group IV-VI semiconductor, a Group IV semiconductor, and a graphene QD. For example, the QD may include at least one of Cd, Se, Zn, S, and InP, but is not limited thereto. Each QD may have a diameter equal to or less than tens of nm, such as a diameter equal to or less than 10 nm. The green conversion layer 152 may include a phosphor that is excited by light emitted from the active layer 143 and emits green light. The green conversion layer 152 may further include a photoresist with high transmission characteristics or a light scattering agent that uniformly emits green light.

The red conversion layer 153 may convert blue light emitted from the active layer 143 into red light and emit the converted red light. The red conversion layer 153 may include QDs with a certain size, which are excited by blue light and emit red light. In addition, the red conversion layer 153 may include a phosphor that is excited by blue light B emitted from the active layer 143 and emits red light. The red conversion layer 153 may further include a photoresist and/or a light scattering agent.

A barrier wall 150 may be provided between the blue conversion layer 151, the green conversion layer 152 and the red conversion layer 153. A reflective film 155 may be further provided on a side surface of the barrier wall 150 to increase the extraction efficiency of light converted from each color conversion layer. Alternatively, the barrier wall 150 may be configured as a black matrix for light absorption. The black matrix may improve contrast by preventing crosstalk between the blue conversion layer 151, the green conversion layer 152, and the red conversion layer 153.

In the structure as described above, for example, when the driving device 135 corresponding to a blue subpixel applies a certain voltage between the first electrode 141 corresponding to the blue subpixel and the second electrode 146 that is a common electrode, for example, blue light may be emitted from the active layer 143 located below the blue conversion layer 151, and when light is incident on the blue conversion layer 151, the blue conversion layer 151 emits blue light to the outside. For example, when the driving device 135 corresponding to a green subpixel applies a certain voltage between the first electrode 141 corresponding to the green subpixel and the second electrode 146, blue light may be emitted from the active layer 143 located below the green conversion layer 152, and when the blue light emitted as such is incident on the green conversion layer 152, the green conversion layer 152 emits green light to the outside.

For example, when the driving device 135 corresponding to a red subpixel applies a certain voltage between the first electrode 141 corresponding to the red subpixel and the second electrode 146, blue light may be emitted from the active layer 143 located below the red conversion layer 153, and the blue light emitted as such may be transmitted through the red conversion layer 153 and emitted to the outside as red light.

According to an example embodiment, a high resolution display apparatus with improved light efficiency may be implemented. According to the related art, to implement a display apparatus, a driving layer and a light emitting unit may each be manufactured and may be coupled to each other. In this case, it may not be easy to electrically couple the driving layer and the light emitting unit, and when the size of a subpixel is reduced to increase resolution, an alignment error rate of the driving layer and the light emitting unit may be increased. On the other hand, according to an example embodiment, the driving layer 130 and the light emitting unit 140 are manufactured using a monolithic integration method, and thus the electrical connection characteristics of the driving layer 130 and the light emitting unit 140 may be excellent, and the size of a subpixel may be reduced based on the isolated structure 147 of the light emitting unit 140, thereby increasing resolution. The thickness of each of the driving layer 130 and the light emitting unit 140 may be minimized.

A display apparatus according to an embodiment includes the isolated structure 147 between neighboring subpixels, and thus current injected from the first electrode may be prevented from spreading to a neighboring subpixel. There is no mesa etching process needed for separation of subpixels, and thus the internal quantum efficiency of the display apparatus may be improved. The driving layer 130 is disposed below the light emitting unit 140, and thus a light emitting area may be increased, thereby improving light emitting efficiency.

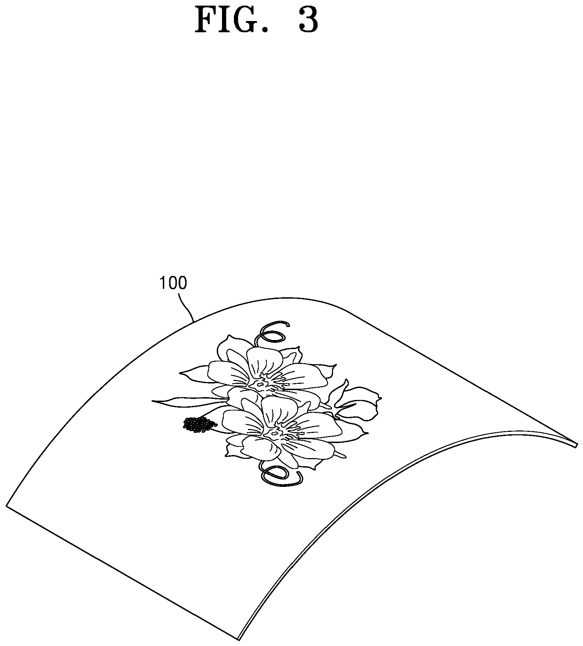

FIG. 3 shows an example in which the display apparatus 100 is flexibly bent according to an embodiment. When the display apparatus 100 has flexibility, the display apparatus 100 may be usefully applied to a wearable display apparatus, for example, a smart watch, an augmented reality (AR) glass, a virtual reality (VR) glass, or a mixed reality (MR) glass.

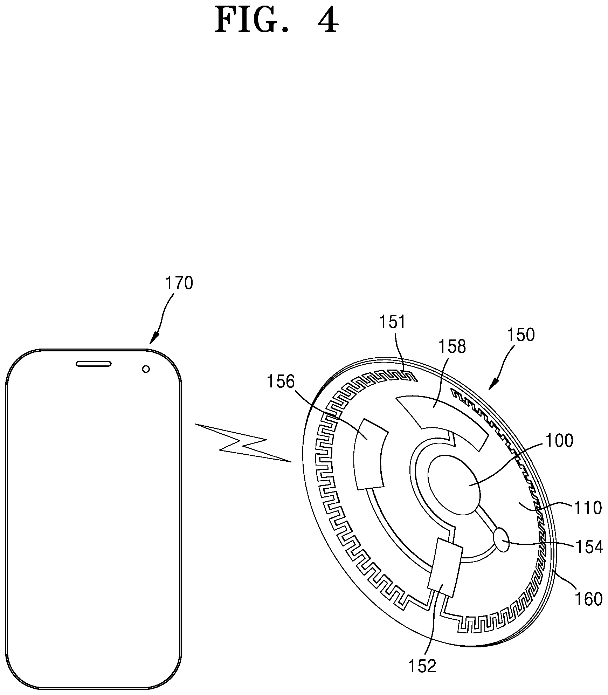

FIG. 4 shows an example in which the display apparatus 100 is applied to a contact lens-type display apparatus, according to an embodiment. The display apparatus 100 is very thin and flexible, and thus may be applied to a contact lens-type display apparatus to be worn and used on the eyes of a user. A contact lens-type display apparatus 150 may include the display apparatus 100, an antenna 151 included in the organic transparent substrate 110 of the display apparatus 100, and a power management integrated circuit (IC) 152 connected to the antenna 151. A sensor 156 and a display driving chip 154 may be connected to the power management IC 152. The sensor 156 may include a simultaneous localization and mapping (SLAM) device. The sensor 156 may match a virtual image and a reality image to each other. For example, the antenna 151 may receive wireless communication data from a wireless communication device 170 such as a smartphone. The display driving chip 154 may be connected to the display apparatus 100 such that the display apparatus 100 forms an image. A power source 158 may be connected to the power management IC 152. The power source 158 may include, for example, a solar cell or supercapacitor. The power supply source 158 may supply power to the power management IC 152. A contact lens 160 may be further disposed on the organic transparent substrate 110. The vision of a user may be corrected by using the contact lens 160. The contact lens-type display apparatus 150 may be formed by integrating the display apparatus 100 with flexibility into a contact lens and may be worn by the user like a contact lens.

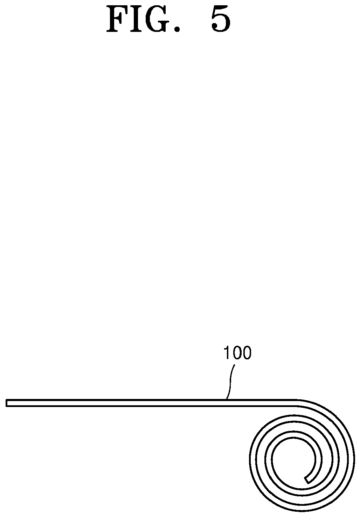

FIG. 5 shows an example in which the display apparatus 100 is applied to a rollable device apparatus, according to an embodiment. The display apparatus 100 may be rolled up and stored, and when the display apparatus 100 is used, the display apparatus 100 may be unfolded to display an image.

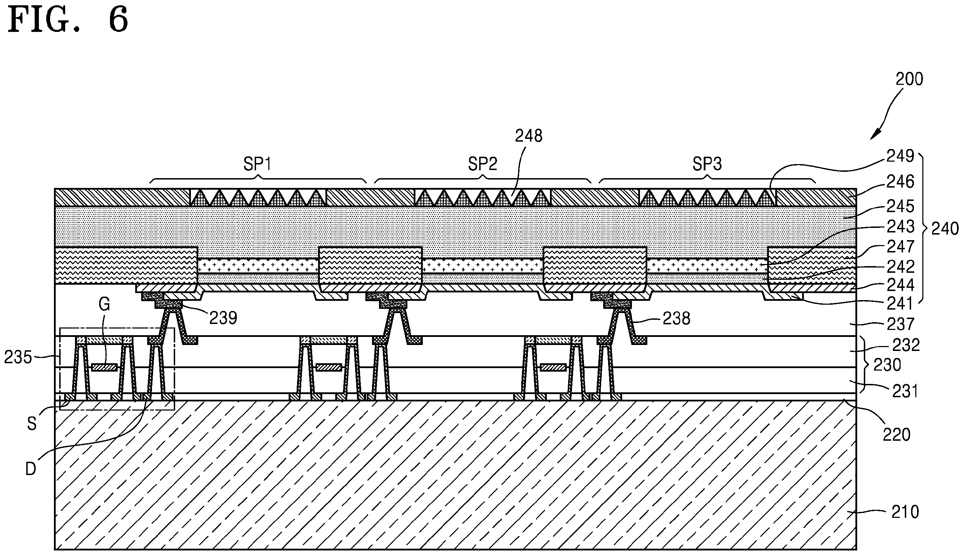

FIG. 6 shows a display apparatus 200 according to an embodiment.

The display apparatus 200 may include the first subpixel SP1, the second subpixel SP2, and the third subpixel SP3. The first subpixel SP1, the second subpixel SP2, and the third subpixel SP3 may emit different color light. The display apparatus 200 may include an organic transparent substrate 210, a driving layer 230 provided on the organic transparent substrate 210, and an inorganic material-based light emitting unit 240 provided on the driving layer 230.

The organic transparent substrate 210 may not be a growth substrate, but a substrate for supporting the driving layer 230 on the organic transparent substrate 210. The driving layer 230 may include a driving device 235 configured to electrically drive the light emitting unit 240 for each subpixel. The driving device 235 may include, for example, a transistor, a thin film transistor (TFT), or a high electron mobility transistor (HEMT). For example, the drive device 235 may include a gate electrode G, a source electrode S, and a drain electrode D. The driving layer 230 may further include at least one insulating layer. For example, at least one insulating layer may include a first insulating layer 231 and a second insulating layer 232. The second insulating layer 232 may be, for example, a gate oxide. A third insulating layer 237 may be further disposed between the driving layer 230 and the light emitting unit 240.

A coupling layer 220 may be disposed between the organic transparent substrate 210 and the driving layer 230. The coupling layer 220 may be used to couple the driving layer 230 to the organic transparent substrate 210, and for example, may include an adhesive layer or a direct bonding layer. The coupling layer 220 may be used to physically couple the driving layer 230 to the organic transparent substrate 210, and may couple the driving layer 230 to the organic transparent substrate 210 by using a bonding method without electrical connection. The coupling layer 220 may cover, for example, the source electrode S and the drain electrode D during a bonding process.

The light emitting unit 240 may include, for example, a micro LED array. The light emitting unit 240 may include a first semiconductor layer 242, an active layer 243, and a second semiconductor layer 245 that are stacked in the order named.

The first semiconductor layer 242 may include a first type semiconductor. For example, the first semiconductor layer 242 may include a p-type semiconductor. The first semiconductor layer 242 may include a Group III-V p-type semiconductor, for example, p-GaN. The first semiconductor layer 242 may have a single or multilayer structure.

The active layer 243 may be provided on an upper surface of the first semiconductor layer 241. The active layer 243 may generate light by combining electrons and holes. The active layer 243 may have a multiquantum well (MQW) or single quantum well (SQW) structure. The active layer 243 may include a Group III-V semiconductor, for example, GaN. The active layer 243 may include a two-dimensional thin film structure or a three-dimensional structure, e.g., a rod or a pyramid structure.

The second semiconductor layer 245 may be provided on an upper surface of the active layer 243. The second semiconductor layer 245 may include, for example, an n-type semiconductor. The second semiconductor layer 245 may include a Group III-V n-type semiconductor, for example, n-GaN. The second semiconductor layer 245 may have a single or multilayer structure.

The light emitting unit 240 may include, for example, an inorganic material-based micro LED array. A micro LED may be provided for each subpixel. The light emitting unit 240 may have an isolated structure 247 such that light from the active layer 243 is emitted on a subpixel basis. In other words, the light emitting unit 240 may have the isolated structure 247 between neighboring subpixels. The micro LED structures may be spaced apart from each other by the isolated structure 247. The isolated structure 247 may be, for example, an ion implantation area. A current is not injected into the ion implantation area, and thus light is not emitted therefrom. The ion implantation area may be formed by implanting ions such as nitrogen ions, or boron ions and may have insulation. For example, ions of about $10^{12}$ ions/cm$^2$ to about $10^{20}$ ions/cm$^2$ dose may be injected into the ion implantation area. However, this is an example and the disclosure is not limited thereto.

The display apparatus 200 may include a first electrode 241 electrically connected to the first semiconductor layer 242 and a second electrode 246 electrically connected to the second semiconductor layer 245. The first electrode 241 may be a pixel electrode, and the second electrode 246 may be a common electrode. When the first and second semiconductor layers 242 and 245 include a p-type semiconductor and an n-type semiconductor, respectively, the first and second electrodes 241 and 246 may be a p-type electrode and an n-type electrode, respectively. The driving device 235 may be electrically connected to the first electrode 241 and may control power on-off of the first electrode 241. Therefore, the driving device 235 may selectively drive at least one desired subpixel of the plurality of subpixels SP1, SP2, and SP3.

The first electrode 241 may include a refractive material to reflect light emitted from the active layer 243 in a downward direction (that is, toward the organic transparent substrate 210). The first electrode 241 may include, for example, Ag, Au, Al, Cr, Ni, or an alloy thereof. The first electrode 241 is a pixel electrode, which may operate subpixels independently. The first electrodes 241 may be spaced apart from each other and may be arranged to face the active layer 243. Current blocking layers 244 may be further provided at both ends of the first electrode 241. The current blocking layer 244 may prevent current from leaking to another adjacent subpixel area. The current blocking layer 244 may be formed of, for example, silicon oxides or silicon nitrides. The current blocking layer 244 may be provided between a lower surface of the isolated structure 247 and the first electrode 241. The current blocking layer 244 may be disposed to correspond to a lower portion of the isolated structure 247.

The insulating layer 237 may be further disposed between the driving layer 230 and the light emitting unit 240. A via hole 238 may be further provided in the insulating layer 237 to electrically connect the driving device 235 and the first electrode 241 to each other. A metal electrode 239 may be further provided between the first electrode 241 and the via hole 238. The metal electrode 239 may be provided to increase the light emitting efficiency of the light emitting unit 240 by increasing electricity efficiency.

The second electrode 246 may be formed as a transparent electrode or an opaque electrode. The transparent electrode may include, for example, indium tin oxide (ITO), ZnO, indium zinc oxide (IZO), or IGZO.

When the second electrode 246 is formed as a transparent electrode, the second electrode 246 may be disposed to entirely cover the second semiconductor layer 245. This will be described in more detail later. When the second electrode 246 is an opaque electrode, the display apparatus 200 may further include a widow region 249 through which light emitted from the active layer 243 is transmitted. The window area 249 may be provided at a position corresponding to the active layer 243.

The second semiconductor layer 245 may include a fine pattern structure 248. The fine pattern structure 248 may increase extraction efficiency of light. The fine pattern structure 248 may be provided in a region corresponding to the active layer 243.

The isolated structure 247 may be provided with a certain thickness from the first semiconductor layer 242. The isolated structure 247 may have a thickness for preventing current from being injected into the first semiconductor layer 242 by the first electrode 241. The current injected from the first electrode 241 needs to be controlled on a subpixel basis so as not to be injected into the first semiconductor layer 242, and current may be injected entirely for the second semiconductor layer 245, and thus the isolated structure 247 may not need to reach a top surface of the second semiconductor layer 245. For example, the isolated structure 247 may have a thickness that is equal to or greater than a sum of the thickness of the first semiconductor layer 242 and the thickness of the active layer 243. Alternatively, the isolated structure 247 may have a thickness for isolation from the first semiconductor layer 242 to the second semiconductor layer 245.

In the present embodiment, among light emitted from the active layer 243, light directed downward (that is, toward the organic transparent substrate 210) may be reflected and may be directed upward by the first electrode 241, and light directed in a lateral direction from the active layer 243 may be directed upward without being absorbed or scattered because the isolated structure 247 does not have a mesa structure. Thus, light emitting efficiency may be improved. The size of the subpixel may be reduced based on the isolated structure 247, which may increase resolution. The fine pattern structure 248 may be provided in the second semiconductor layer 245 to increase external quantum efficiency. The fine pattern structure 248 may be provided in the window region 249. In addition, the present embodiment may have a vertical electrode structure in which the first electrode 241 and the second electrode 246 are disposed up and down based on the active layer 243. The second electrode 246 may be disposed at one side of the active layer 243, and the second electrode 246 may be manufactured without a via hole process, and accordingly, electrodes may be formed without a mesa structure.

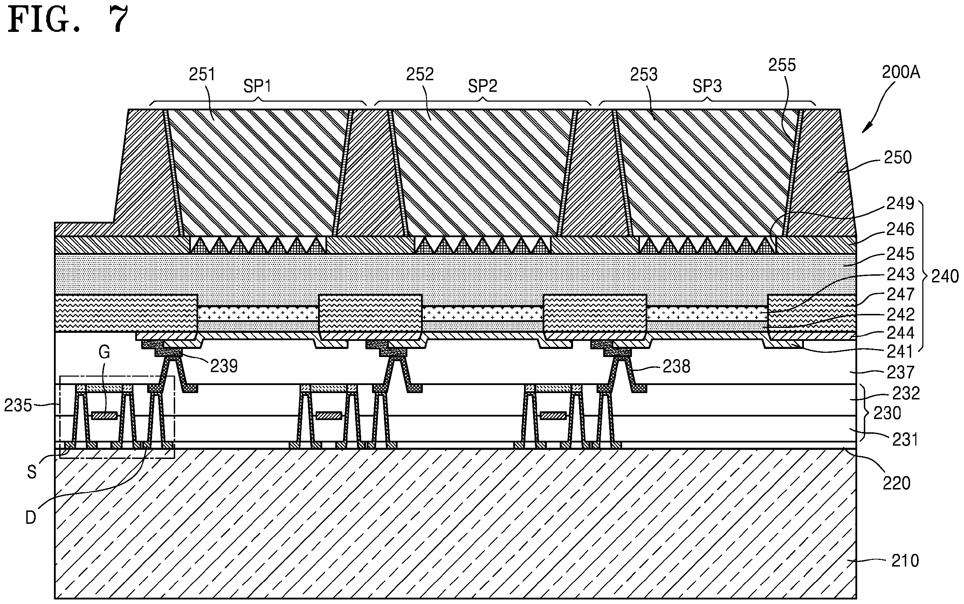

FIG. 7 shows a display apparatus 200A including a color conversion layer in the structure shown in FIG. 6. In FIG. 7, components using the same references as those in FIG. 6 have substantially the same functions and configurations as those described in FIG. 6, and thus, detailed descriptions thereof are omitted here.

The display apparatus 200A may include an organic transparent substrate 210, a driving layer 230, an inorganic material-based light emitting unit 240, and color conversion layers 251, 252, and 253.

The plurality of color conversion layers 251, 252, and 253 that emit light with different colors by using light emitted from the active layer 243 of the light emitting unit 240 may be provided on or above the light emitting unit 240. The active layer 243 may emit, for example, blue light. However, this is only an example, and it may also be possible to emit light with other wavelengths, which may excite the color conversion layers 251, 252, and 253. The plurality of color conversion layers 251, 252, and 253 may be provided to correspond to the subpixels SP1, SP2, and SP3, respectively. The plurality of color conversion layers 251, 252, and 253 may include, for example, a blue conversion layer, a green conversion layer, and a red conversion layer. The blue conversion layer 251 may correspond to a blue subpixel, the green conversion layer 252 may correspond to a green subpixel, and the red conversion layer 253 may correspond to a red subpixel. The blue conversion layer 251, the green conversion layer 252, and the red conversion layer 253 are substantially the same as the blue conversion layer 151, the green conversion layer 152, and the red conversion layer 153 described in FIG. 2, and a detailed description thereof is omitted.

The color conversion layers 251, 252, and 253 may have a cross-sectional shape that is wider upward. A barrier wall 250 may be provided between the neighboring color conversion layers 251, 252, and 253. A reflective film 255 may be further provided on a side surface of the barrier wall 250 to increase the extraction efficiency of light that is converted from each color conversion layer. Alternatively, the barrier wall 250 may be configured as a black matrix for light absorption. The black matrix may improve contrast by preventing crosstalk between the blue conversion layer 251, the green conversion layer 252, and the red conversion layer 253.

For example, blue light may be emitted from each subpixel of the light emitting unit 240, and based on the blue light, color light corresponding to a color conversion layer of each subpixel may be emitted. Light intensity may be controlled by the amount of current injected into the first electrode 241 and the second electrode 246, and color light may be emitted by a color conversion layer in a subpixel, and thus a color image may be displayed. According to an example embodiment, even if the size of a subpixel is reduced, leakage of light to a neighboring subpixel may be reduced or prevented by an isolated structure, thereby increasing the resolution of the display apparatus.

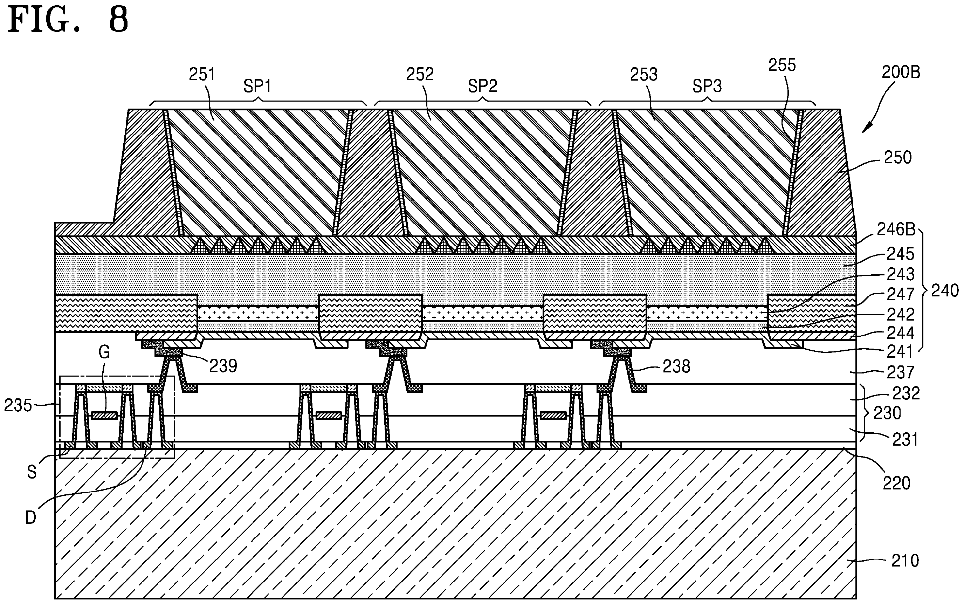

FIG. 8 shows an example of a display apparatus 200B in which the structure of the second electrode is changed compared with FIG. 7.

Referring to FIG. 8, a second electrode 246B may be formed as a transparent electrode in the display apparatus 200B. The second electrode 246B may include, for example, indium tin oxide (ITO), ZnO, indium zinc oxide (IZO), or IGZO. The second electrode 246B may be a common electrode and may be provided in one plate. The second electrode 246B may be arranged to entirely cover the second semiconductor layer 245. In this case, when the second electrode 246B is configured as a transparent electrode, manufacturing processes may be simplified because there is no need for a window region to allow light to be transmitted therethrough.

A display apparatus according to an embodiment may be applied to, for example, a flexible display, a rollable display, a head up display, a contact lens-type display, a virtual reality (VR) glass, or an augmented reality (AR) glass. A display apparatus according to an embodiment may be applied to various products.

Hereinafter, a method of manufacturing a display apparatus according to an embodiment will be described.

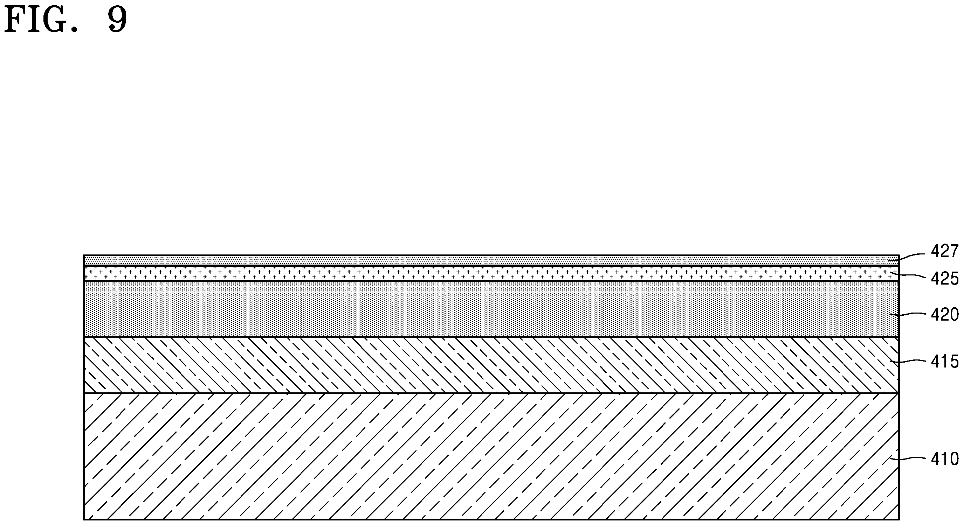

Referring to FIG. 9, a first semiconductor layer 420, a first layer 425, and a second semiconductor layer 427 may be grown on an epitaxial substrate 410. The epitaxial substrate 410 may be, for example, a silicon substrate or a sapphire substrate. However, the epitaxial substrate 410 is not limited thereto, but various epitaxial substrates may be used. The first semiconductor layer 420 may include an n-type semiconductor layer. In some cases, however, the first semiconductor layer 420 may include a p-type semiconductor layer. For example, the first semiconductor layer 420 may include an n-type GaN. The first layer 425 is a layer on which an active layer is formed, and for example, may include GaN. A buffer layer 415 may be formed between the epitaxial substrate 410 and the first semiconductor layer 420. The buffer layer 415 may include a single or multilayer structure and may facilitate growth of the first semiconductor layer 420. The buffer layer 415 may include, for example, AlN. An undoped semiconductor layer (not shown), for example, u-GaN, may be further provided between the buffer layer 415 and the first semiconductor layer 420.

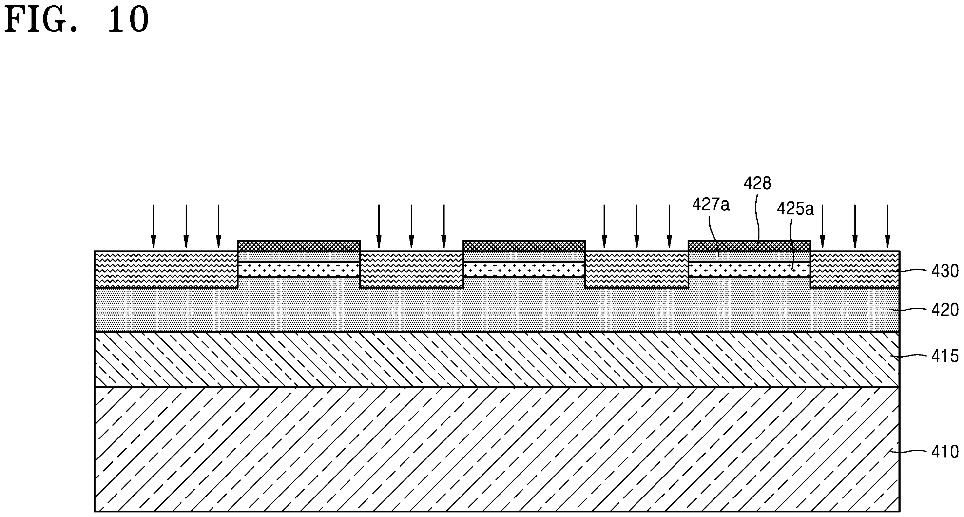

Referring to FIGS. 9 and 10, an isolated structure 430 may be formed on the first layer 425 and the second semiconductor layer 427 using a mask 428. The mask 428 may be, for example, an ion implantation mask. For example, the isolated structure 430 may be formed by implanting ions into a certain region of the first layer 425 and the second semiconductor layer 427. Ions may include, for example, nitrogen (N) ions, boron (B) ions, argon (Ar) ions, or phosphorus (P) ions. However, ions are not limited thereto. FIG. 10 shows an example in which the isolated structure 430 is formed on the first layer 425 and the second semiconductor layer 427, but the thickness of the isolated structure 430 may be variously determined. For example, the isolated structure 430 may be formed to a partial depth of the first semiconductor layer 420 from the second semiconductor layer 427. An active layer 425a and a second semiconductor layer 427a that are spaced apart from each other by the isolated structure 430 may be formed. The active layer 425a and the second semiconductor layer 427a that are spaced apart from each other may define a subpixel region. A micro LED array may be formed based on the isolated structure 430.

When subpixels are electrically separated by the ion implantation area, an edge portion of the active layer 425a in which a defect may exist may be disabled through ion implantation, thereby inducing light emission only from inside the active layer 425a. Pixels (or subpixels) may be electrically separated by the ion implantation area, thereby preventing local contrast degradation. Local contrast degradation occurs when light is unintentionally emitted to adjacent pixels (subpixels) at a pixel (subpixel) boundary of a horizontal mesa-free structure in which structural separation between pixels (subpixels) is not achieved. However, in the present embodiment, contrast may be improved by preventing current from spreading to adjacent pixels (subpixels) by using the mesa-free isolated structure.

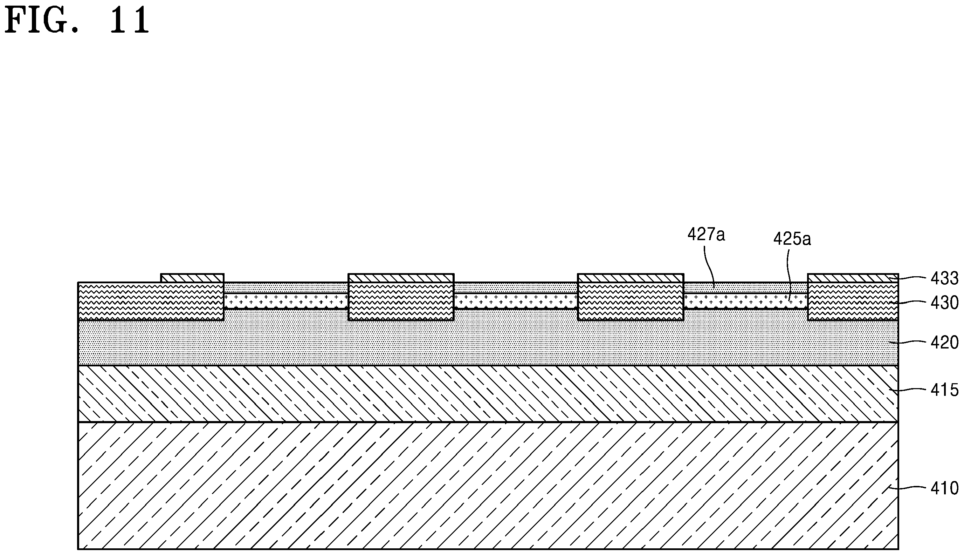

Referring to FIG. 11, a current blocking layer 433 may be deposited on or above the isolated structure 430. The current blocking layer 433 may be formed through a photoresist and an etching process. The current blocking layer 433 may be formed of an insulating material. The current blocking layer 433 may electrically insulate the first electrodes to be formed later. In an embodiment, the current blocking layer 433 may be omitted.

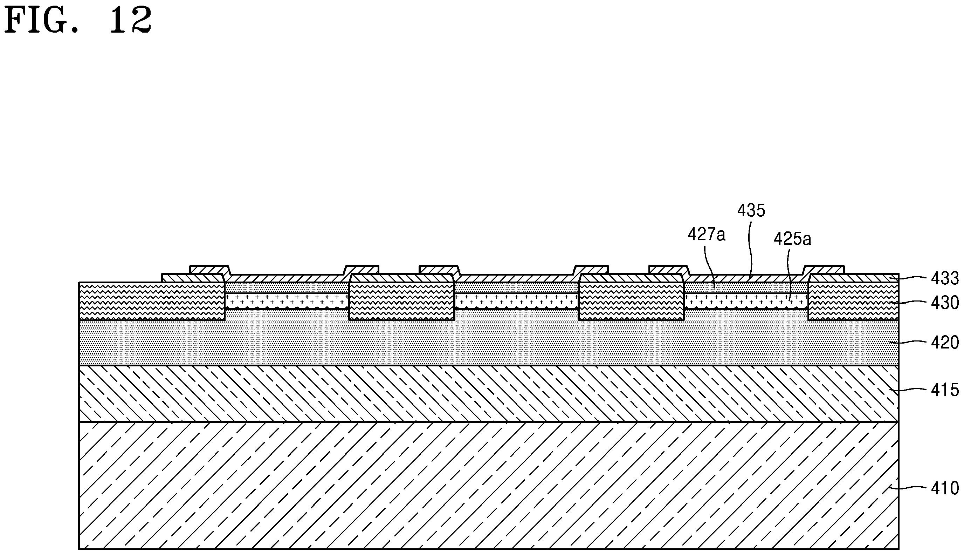

Referring to FIG. 12, a conductive material may be deposited on the structure shown in FIG. 11 to form first electrodes 435 spaced apart from each other on a subpixel basis through etching. The first electrode 435 may be a pixel electrode that operates on a subpixel basis. The first electrode 435 may be formed of a reflective conductive material. The first electrode 435 may include, for example, Ag, Au, Al, Cr, Ni, or an alloy thereof. The first electrode 435 may be an opaque electrode.

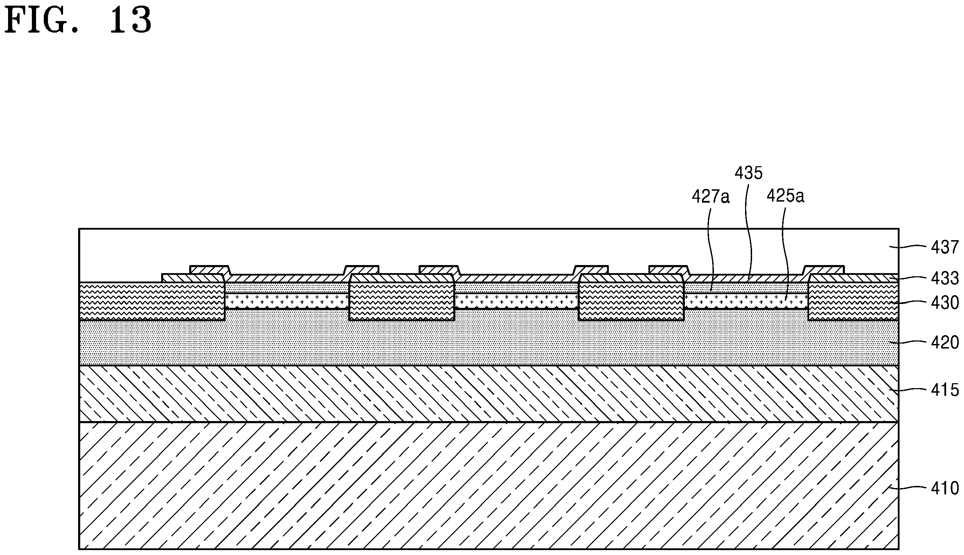

Referring to FIG. 13, a first insulating layer 437 may be formed to cover the first electrode 435. The first insulating layer 437 may include, for example, $SiO_2$, SiN, $Al_2O_3$, or $TiO_2$, but is not limited thereto.

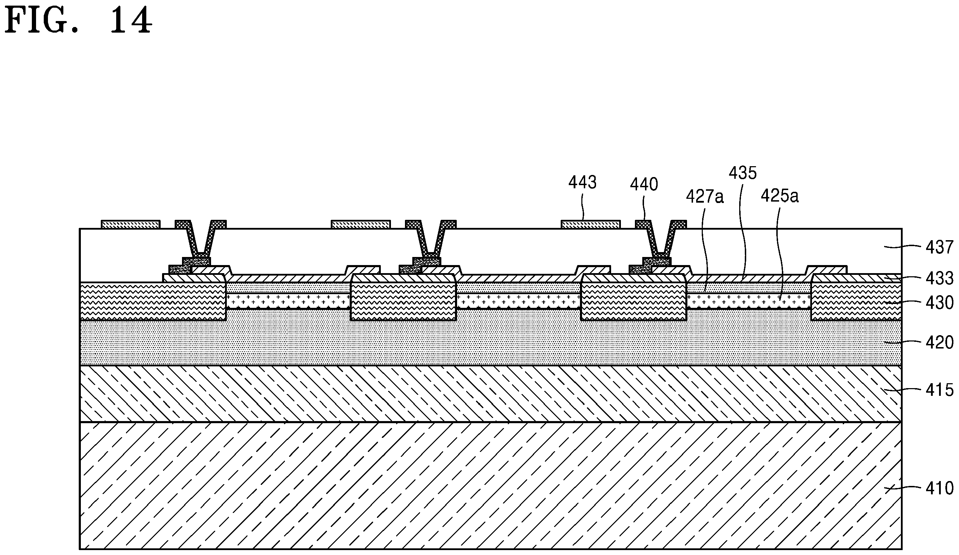

Referring to FIG. 14, the first insulating layer 437 may be etched and deposited with a conductive material to form a via hole 440 and an electrode pad 443. A via hole 440 may be in contact with the first electrode 435. Alternatively, a metal electrode 439 may be formed in contact with a portion of the first electrode 435 before the via hole 440 is formed. The via hole 440 may be in contact with the metal electrode 439.

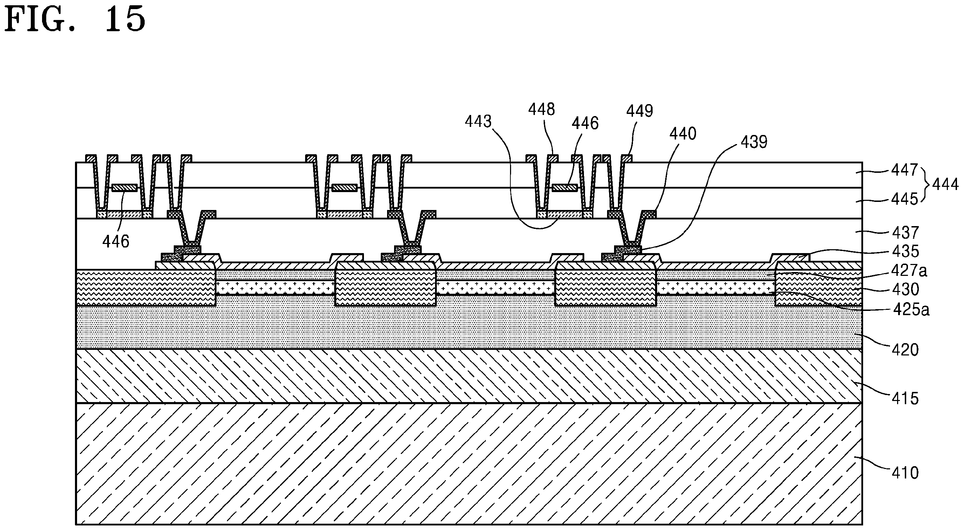

Referring to FIG. 15, a second insulating layer 445 may be formed on the first insulating layer 437 and a gate electrode 446 may be formed on the second insulating layer 445. A third insulating layer 447 may be formed on the second insulating layer 445 and the gate electrode 446. A source electrode 448 and a drain electrode 449 may be formed by etching the second insulating layer 445 and the third insulating layer 447. The gate electrode 446, the source electrode 448, and the drain electrode 449 may constitute a driving device. Here, a method of forming a thin film transistor as an example of a driving device is described. The source electrode 448 may be connected to the electrode pad 443, and the drain electrode 449 may be connected to the via hole 440. Accordingly, a driving layer 444 may be formed.

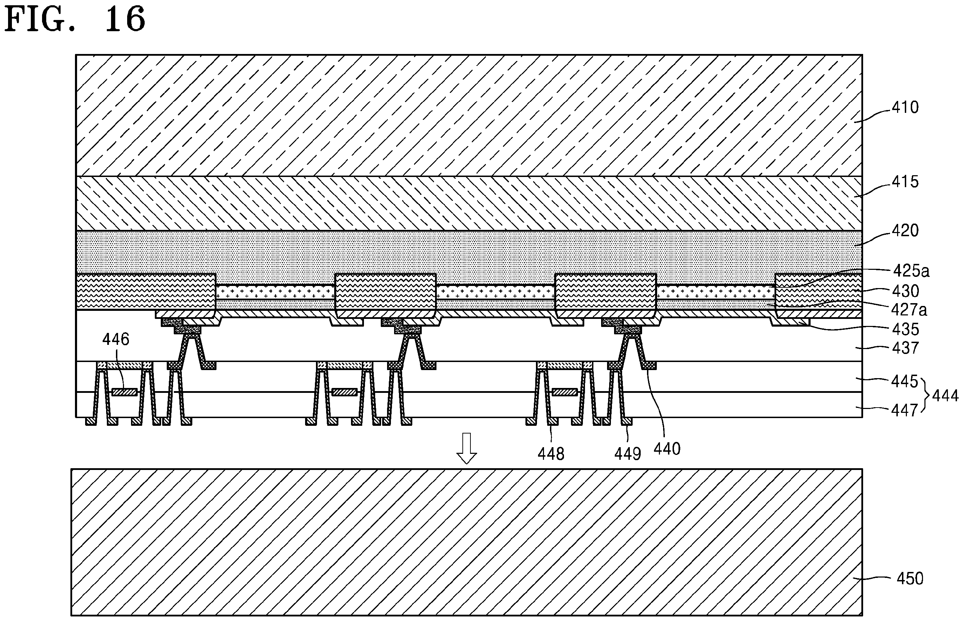

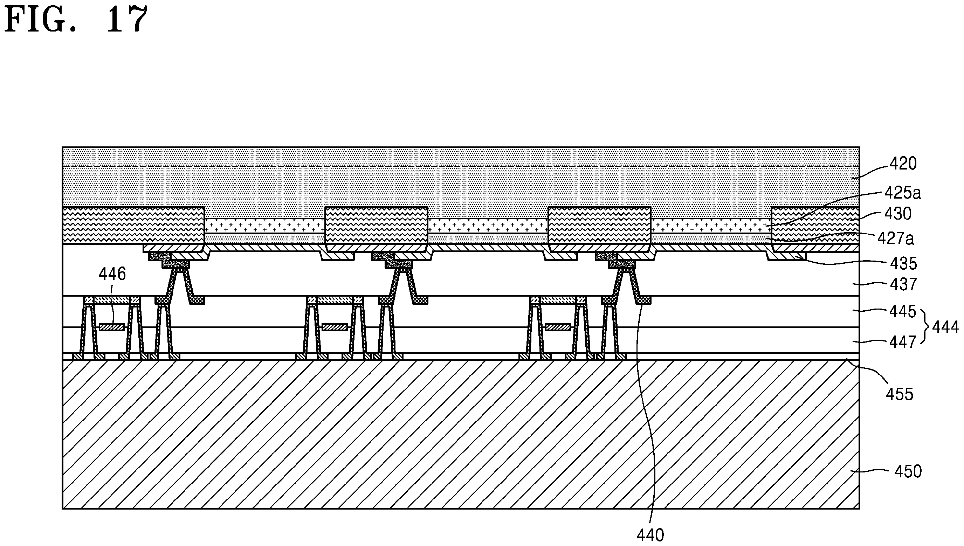

Referring to FIG. 16, the structure shown in FIG. 15 may be reversed such that the epitaxial substrate 410 is on the top, and the structure may be disposed such that the third insulating layer 447 faces an organic transparent substrate 450. The organic transparent substrate 450 may be a substrate for supporting the structure shown in FIG. 15, and the organic transparent substrate 450 may be a flexible transparent substrate, and for example, may include polyimide, polymethyl methacrylate (PMMA), plexiglass, polyethylene terephthalate (PET), transparent polypropylene, poly polycarbonate, polyethylene naphthalate, polyarylate (PAR), polyetherimide, or any combination thereof. Referring to FIG. 17, the organic transparent substrate 450 and the third insulating layer 447 may be coupled to each other by a coupling layer 455. The coupling layer 455 may include, for example, an adhesive layer, or a direct bonding layer. The organic transparent substrate 450 may not require electrical connection and may support the structure, and the organic material transparent substrate 450 and the structure shown in FIG. 15 may be physically coupled to each other via simple bonding. The coupling layer 455 may have a thickness in the range of about 0.1 nm to about 10 $\mu$m, for example.

After the driving layer 444 is coupled to the organic transparent substrate 450, the epitaxial substrate 410 may be removed. The epitaxial substrate 410 may be removed, for example, by a laser lift off method or a polishing method. The polishing method may be used with a dry etching method. For example, when the epitaxial substrate 410 is a sapphire substrate, the epitaxial substrate 410 may be removed by the laser lift off method, and when the epitaxial substrate 410 is a silicon substrate, the epitaxial substrate 410 may be removed by the polishing method.

While the epitaxial substrate 410 is mechanically removed, a total grinding force F may be divided into a normal direction grinding force Fn and a tangent direction grinding force Ft.

$$F = Fn + Ft$$

As shown below, when Ft is smaller than adhesion G of a transparent inorganic substrate interface, there is no peeling of the organic transparent substrate during mechanical polishing.

$$Ft < G$$

The tangent direction grinding force Ft may monotonically increase as a wafer rotation speed increases, an abrasive wheel feed rate increases, and a wheel rotation speed decreases. Ft has a correlation with a sliding force, and G increases according to a sliding speed by a systematic steering molecular dynamics simulation. Based on this, an absolute value of G may be kept high by appropriately selecting an organic transparent substrate having a higher rigidity and a lower thermal expansion coefficient, for example, polyimide, exposing the same to ultraviolet (UV) radiation, and controlling a polyimide curing time. Thus, Ft and G may increase together as a sliding speed increase while maintaining Ft <G to sufficiently increase a process window.

Wheel feed rate <150 ($\mu$m/min)
Wheel speed > 1000 rpm
Wafer rotation speed < 400 rpm

Under the above conditions, the epitaxial substrate 410 may be removed without peeling of a polyimide film.

For example, the epitaxial substrate 410 may be polished in two stages.

<First stage>

Wheel feed rate: 1.5 to 2 um/sec,
Wheel speed: 1500 rpm
Wafer rotation speed: 250 rpm

<Second stage>

Wheel feed rate: 0.5 um/sec
Wheel speed: 2800 rpm,
Wafer rotation speed: 150 rpm.

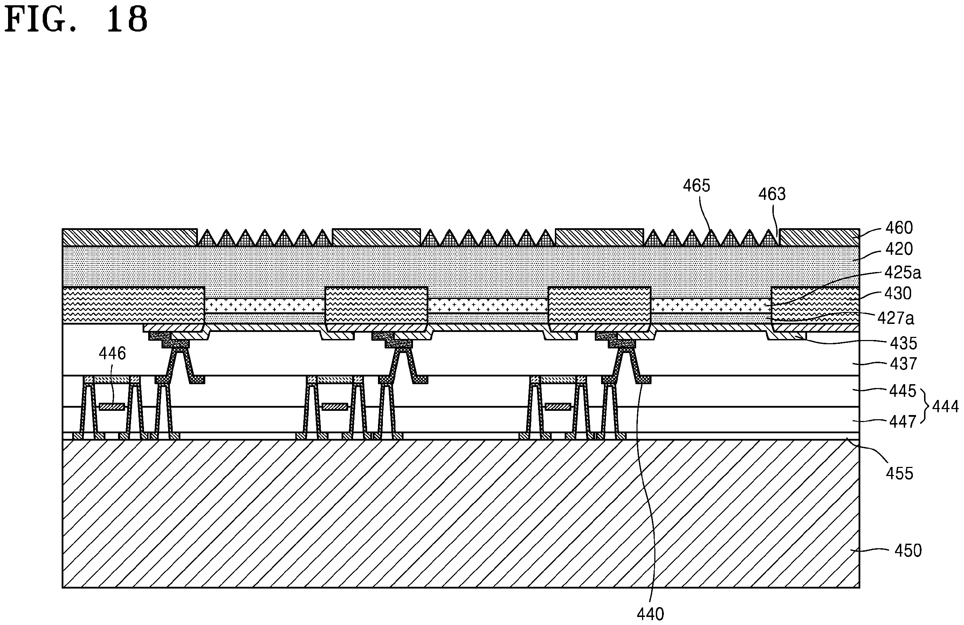

The buffer layer 415 may be selectively removed. FIG. 17 shows an example in which the buffer layer 415 is removed. The first semiconductor layer 420 may be etched to reduce a thickness thereof. For example, the first semiconductor layer 420 may have a thickness of about 0.5 $\mu$m to about 3.0 $\mu$m. Referring to FIG. 18, a fine pattern structure 465 may be formed by a wet etching process in the first semiconductor layer 420. The fine pattern structure 465 may be formed to correspond to an area from which light is emitted. For example, the fine pattern structure 465 may be formed at a position corresponding to an active layer 427a. The fine pattern structure 465 may increase the extraction efficiency of light. A second electrode 460 may be formed on the first semiconductor layer 420. The second electrode 460 may be formed as an opaque electrode. When the second electrode 460 is an opaque electrode, the second electrode 460 may be etched to form a window region 463 to allow light to be emitted therefrom.

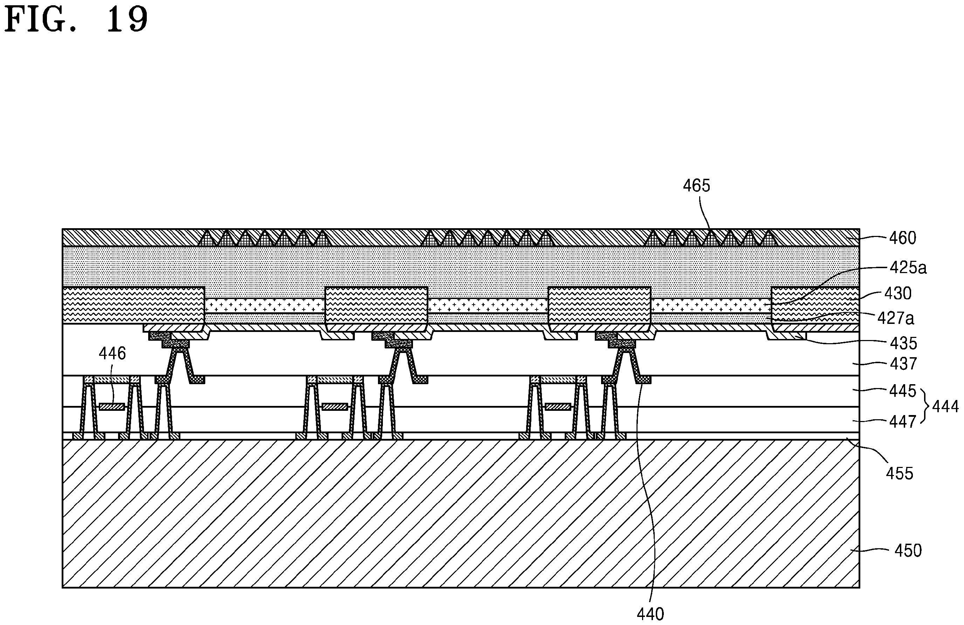

FIG. 19 shows an example of a second electrode 460 formed of a transparent electrode, unlike FIG.

18. The second electrode 460 may include, for example, indium tin oxide (ITO), ZnO, indium zinc oxide (IZO), or IGZO. When the second electrode 460 is a transparent electrode, the second electrode 460 may be disposed to entirely cover the second semiconductor layer 420. The window region may not be required because the transparent electrode may allow light to pass therethrough without change. The second electrode 460 may be a common electrode, and the structure thereof is simple, and thus the second electrode 460 may be simply manufactured, and a manufacturing error may be reduced. A driving layer including a thin film transistor may be disposed below the active layer 427a, and the second electrode 460 as a common electrode may be disposed above the active layer 427a, and thus an area from which light is emitted may be easily ensured. The first electrode 435 may be disposed below the active layer 427a such that light emitting downward from the active layer 427a is reflected by the first electrode 435, thereby increasing light emitting efficiency.

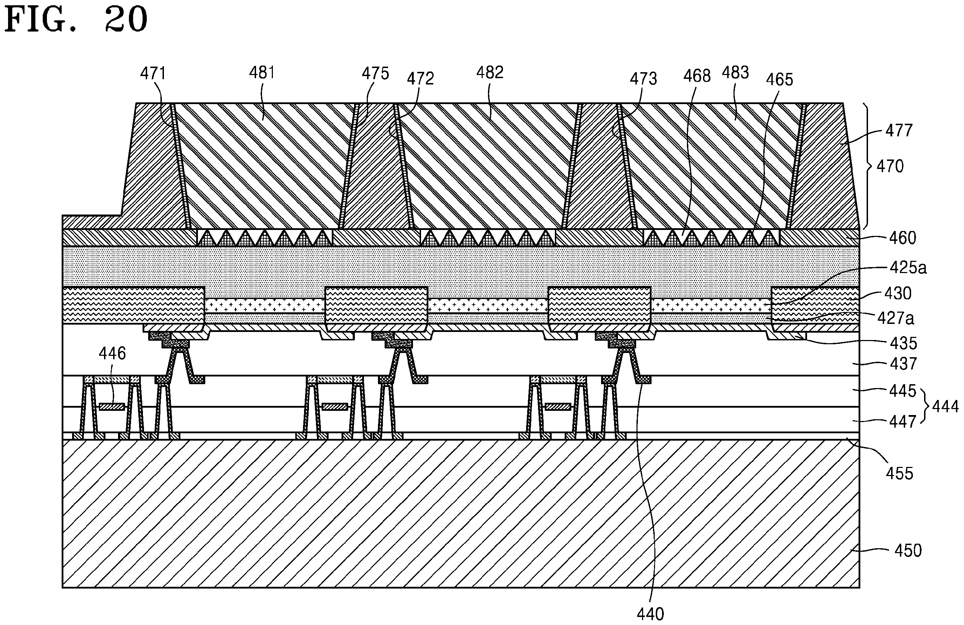

Referring to FIG. 20, a plurality of color conversion layers, for example, first, second and third color conversion layers 481, 482, and 483, may be formed on the second electrode 460. The first, second, and third color conversion layers 481, 482, and 483 may be separated by a barrier wall 477. A barrier wall layer 470 may be stacked on the second electrode 460, a first hole 471 for the first color conversion layer 481 may be formed using a first mask (not shown), and the first color conversion layer 481 may be deposited on the first hole 471. Before the first color conversion layer 481 is deposited, a reflective film 475 may be formed on a side wall of the first hole 471. A second hole 472 for the second color conversion layer 482 may be formed using a second mask (not shown), and the second color conversion layer 482 may be deposited on a second hole 472. Before the second color conversion layer 482 is deposited, the reflective film 475 may be formed on a side wall of the second hole 472. A third hole 473 for the third color conversion layer 483 may be formed using a third mask (not shown), and the third color conversion layer 483 may be deposited on the second hole 473. Before the third color conversion layer 483 is deposited, the reflective film 475 may be formed on a side wall of the third hole 473. Through the above process, the barrier wall 477 may be formed between neighboring color conversion layers.

In a method of manufacturing a display according to an embodiment, an inorganic material-based light emitting unit may be coupled to an organic transparent substrate. The driving layer and the light emitting unit may be formed by a monolithic integration method, and thus may be very thin and a pixel size may be reduced. In a method of manufacturing a display according to an embodiment, the epitaxial substrate may be reversed to the top and coupled to an organic transparent substrate, and then a vertical electrode structure without a mesa structure may be formed through a flip manufacturing process. During the flip manufacturing process, the organic material transparent substrate may support the driving layer and the light emitting unit without damage, and thus a flexible display apparatus may be manufactured. In a method of manufacturing a display according to an embodiment, a manufacturing process may be simplified by shortening a via hole etching process to form electrodes, and there is no mesa structure, and accordingly, a decrease in internal quantum efficiency due to the mesa structure may be prevented. At least one of the first electrode and the second electrode may function as a reflective film, thereby increasing light emitting efficiency.

A display apparatus according to an embodiment may have flexibility by coupling an inorganic light emitting unit to an organic transparent substrate. In a display apparatus according to an embodiment, a driving layer and a light emitting unit have a monolithic integration structure, thereby reducing a pixel size and increasing resolution.

A method of manufacturing a display apparatus according to an embodiment may provide a method of coupling an inorganic light emitting unit to an organic transparent substrate.

The above-described example embodiments are merely illustrative, and various modifications and other equivalent embodiments may be made by a person skilled in the art. Thus, the true scope of an embodiment needs to be determined by the claims and their equivalents.

It should be understood that embodiments described herein should be considered in a descriptive sense only and not for purposes of limitation. Descriptions of features or aspects within each embodiment should typically be considered as available for other similar features or aspects in other embodiments.

While one or more example embodiments have been described with reference to the figures, it will be understood by those of ordinary skill in the art that various changes in form and details may be made therein without departing from the scope as defined by the following claims and their equivalents.

**Claims**

1.   A display apparatus comprising:

a pixel electrode configured to supply power to a subpixel;
a common electrode;
an organic transparent substrate;
a driving layer provided on the organic transparent substrate and electrically connected to the pixel electrode, the driving layer including a driving device configured to control power on-off of the subpixel; and
a light emitting unit provided on the driving layer and including an inorganic material, the light emitting unit including a first semiconductor layer, an active layer, and a second semiconductor layer.

2. The display apparatus of claim 1,
wherein the organic transparent substrate includes at least one of polyimide, polymethyl methacrylate, PMMA, plexiglass, polyethylene terephthalate, PET, transparent polypropylene, polycarbonate, polyethylene naphthalate, polyarylate, PAR, polyetherimide, or any combination thereof.

3. The display apparatus of claim 1 or 2, wherein the display apparatus is a flexible display apparatus or a rollable display apparatus.

4. The display apparatus of any preceding claim, further comprising:

a coupling layer between the organic transparent substrate and the driving layer,
and optionally wherein the coupling layer includes at least one of benzocyclobutene, BCB, epoxy, or spin on glass, SOG.

5. The display apparatus of any preceding claim, wherein the light emitting unit includes a light emitting diode, LED, array structure.

6. The display apparatus of any preceding claim, wherein the driving layer has a thickness of 2 $\mu$m or less.

7. The display apparatus of any preceding claim, wherein the light emitting unit has a thickness of 2 $\mu$m to 3 $\mu$m.

8. The display apparatus of any preceding claim, wherein the display apparatus has a pixel integration degree greater than or equal to 2,000 pixels per inch, ppi.

9. The display apparatus of any preceding claim, wherein the driving layer and the light emitting unit have a monolithic integration structure.

10. The display apparatus of any preceding claim, wherein the light emitting unit includes an isolated structure that isolates at least a part of a light emitting structure on a subpixel basis, and optionally further comprising:
a current blocking layer in an area corresponding to the isolated structure of the driving layer.

11. The display apparatus of any preceding claim, further comprising:
a plurality of color conversion layers configured to convert light emitted from the light emitting unit into light with different colors.

12. A method of manufacturing a display apparatus, the method comprising:

forming a first semiconductor layer on an epitaxial substrate;
forming an active layer on the first semiconductor layer, the active layer including an inorganic material;
forming a second semiconductor layer on the active layer;
isolating the active layer on a subpixel basis by forming isolated structures on the active layer at an interval corresponding to a subpixel;
forming a first electrode on a subpixel basis on the second semiconductor layer;
forming a driving layer including a driving device, the driving device being electrically connected to the first electrode;
positioning the driving layer to face down and coupling the driving layer to an organic transparent substrate;
removing the epitaxial substrate; and
forming a second electrode on the first semiconductor layer.

13. The method of claim 12,
wherein the isolating the active layer on a subpixel basis comprises forming an ion implantation area.

14. The method of claim 12,
wherein the organic transparent substrate includes at least one of polyimide, polymethyl methacrylate, PMMA, plexiglass, polyethylene terephthalate, PET, transparent polypropylene, polycarbonate, polyethylene naphthalate, polyarylate, PAR, polyetherimide, or any combination thereof.

15. The method of claim 12,
wherein the organic transparent substrate is a flexible transparent substrate.

# FIG. 1

# FIG. 2

# FIG. 3

# FIG. 4

# FIG. 5

100

FIG. 6

# FIG. 7

EP 4 481 818 A1

# FIG. 8

EP 4 481 818 A1

FIG. 9

427
425
420
415
410

# FIG. 10

EP 4 481 818 A1

# FIG. 11

# FIG. 12

# FIG. 13

EP 4 481 818 A1

FIG. 14

EP 4 481 818 A1

# FIG. 15

EP 4 481 818 A1

# FIG. 16

EP 4 481 818 A1

FIG. 17

EP 4 481 818 A1

# FIG. 18

FIG. 19

EP 4 481 818 A1

# FIG. 20

EP 4 481 818 A1

## EUROPEAN SEARCH REPORT

Application Number

EP 24 17 5039

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/132423 A1 (CHEN ZHEN [US] ET AL) 4 May 2023 (2023-05-04) * paragraph [0024] - paragraph [0055]; figures 1-9 * | 1-15 | INV. H01L25/16 H01L27/15 |
| X | US 2022/352277 A1 (KIM SOO CHUL [KR] ET AL) 3 November 2022 (2022-11-03) * paragraph [0078] * * paragraph [0110] - paragraph [0129]; figure 7 * * paragraph [0248] - paragraph [0283]; figures 3, 14A, 14B * | 1-11 | ADD. H01L33/50 H01L33/00 |
| X | US 2019/214376 A1 (KIM EUN JU [KR]) 11 July 2019 (2019-07-11) * paragraph [0038] * * paragraph [0058] - paragraph [0062] * * paragraph [0091] - paragraph [0100]; figures 5-8 * | 1-11 | |
| A | US 2020/168663 A1 (CHOI JUNHEE [KR] ET AL) 28 May 2020 (2020-05-28) * paragraph [0064] - paragraph [0151]; figures 1-20 * | 1-15 | **TECHNICAL FIELDS SEARCHED (IPC)** H01L |

The present search report has been drawn up for all claims

| Place of search | Date of completion of the search | Examiner |
|---|---|---|
| The Hague | 18 October 2024 | Franssen, Gijs |

EPO FORM 1503 03.82 (P04C01)

## ANNEX TO THE EUROPEAN SEARCH REPORT
## ON EUROPEAN PATENT APPLICATION NO.

EP 24 17 5039

This annex lists the patent family members relating to the patent documents cited in the above-mentioned European search report.
The members are as contained in the European Patent Office EDP file on
The European Patent Office is in no way liable for these particulars which are merely given for the purpose of information.

18-10-2024

| Patent document cited in search report | Publication date | Patent family member(s) | Publication date |
|---|---|---|---|
| US 2023132423 A1 | 04-05-2023 | EP 4427272 A1 | 11-09-2024 |
| | | TW 202329250 A | 16-07-2023 |
| | | US 2023132423 A1 | 04-05-2023 |
| | | WO 2023081043 A1 | 11-05-2023 |
| US 2022352277 A1 | 03-11-2022 | CN 115274684 A | 01-11-2022 |
| | | US 2022352277 A1 | 03-11-2022 |
| US 2019214376 A1 | 11-07-2019 | CN 110021620 A | 16-07-2019 |
| | | KR 20190085197 A | 18-07-2019 |
| | | KR 20230054333 A | 24-04-2023 |
| | | US 2019214376 A1 | 11-07-2019 |
| | | US 2023307432 A1 | 28-09-2023 |
| US 2020168663 A1 | 28-05-2020 | CN 111223885 A | 02-06-2020 |
| | | EP 3660900 A1 | 03-06-2020 |
| | | JP 7402023 B2 | 20-12-2023 |
| | | JP 2020086461 A | 04-06-2020 |
| | | KR 20200062863 A | 04-06-2020 |
| | | US 2020168663 A1 | 28-05-2020 |
| | | US 2021375983 A1 | 02-12-2021 |

EPO FORM P0459

For more details about this annex : see Official Journal of the European Patent Office, No. 12/82